# EUROPÄISCHE PATENTSCHRIFT

(11) **EP 0 386 473 B1**
(45) Veröffentlichungstag und Bekanntmachung des Hinweises auf die Patenterteilung: **11.12.1996**
(21) Anmeldenummer: 90102249.1
(22) Anmeldetag: 05.02.1990
(51) Int. Cl.: H01L 23/28, H01L 21/56

(54) **Tropfenabdeckmassen für elektrische und elektronische Bauelemente**
Drop-covering mass for electric and electronic devices
Pâte de recouvrement en goutte pour modules électriques et électroniques

(30) Priorität: 08.03.1989 DE 3907535
(43) Veröffentlichungstag der Anmeldung: 12.09.1990
(73) Patentinhaber: SIEMENS AKTIENGESELLSCHAFT, 80333 München (DE)
(72) Erfinder: Bayer, Heiner, Dr. rer. nat., D-8037 Olching (DE); Lehner, Barbara, D-8000 München 21 (DE); Fritsch, Hans-Peter, D-8000 München 70 (DE); Wohak, Kurt, Dr. phil., D-8000 München 90 (DE)

(56) Entgegenhaltungen:
- EP-A- 0 114 258
- GB-A- 2 086 134
- US-A- 4 479 990
- US-A- 4 703 338
- PATENT ABSTRACTS OF JAPAN vol. 11, no. 30 (C-400)(2477) 29 Januar 1987,
- & JP-A- 61 203119 (FUJITSU) 09 September 1986,

## Beschreibung

Die Erfindung betrifft Tropfenabdeckmassen mit niedrigen thermischen Ausdehnungskoeffizienten für elektrische und elektronische Bauelemente.

Verschiedene elektronische Bauelemente, insbesondere integrierte Schaltungen werden in einer Vielzahl von Arbeitsschritten auf einem Substrat, zum Beispiel einem Halbleitermaterial, aufgebaut. Nach Herstellung der Bauelemente/Chips werden diese aufgeklebt, -gelötet, -legiert und schließlich durch feine Bonddrähte oder Kupferbändchen mit den elektrischen Anschlüssen verbunden. Zum Schutz der Schaltung und der freiliegenden Bonddrähte können die Bauelemente mit einem Gehäuse versehen und/oder mit einer elektrisch isolierenden Kunststoffmasse vergossen oder umpreßt werden. Andere Bauelemente werden als "nackter", ungehäuster IC weiter verwendet. Auch hier muß die offenliegende Schaltung nach dem Einbau in eine Hybridschaltung in ein Gerät oder in eine Transportvorrichtung gegen Umgebungseinflüsse, zum Beispiel Feuchtigkeit, Staub oder mechanische Beschädigung geschützt werden. Eine einfache Möglichkeit zum Schutz solcher Bauelemente ist die Tropfenabdeckung. Dazu werden Reaktionsharze in geeigneten Vorrichtungen auf die zu schützenden Bereiche bzw. Schaltungen aufgetropft und anschließend gehärtet.

Zur Tropfenabdeckung geeignete Reaktionsharze müssen verschiedene Anforderungen erfüllen. Insbesondere darf die mit dem Bauelement in direktem Kontakt stehende Masse die Funktion des Bauelements nicht beeinträchtigen. Deshalb darf die Masse unter anderem weder bei der Härtung noch beim späteren Betrieb eine allzu große Volumenänderung infolge größerer Temperaturunterschiede zeigen. Ein zu großer thermischer Ausdehnungskoeffizient und eine im Bereich der Betriebstemperaturen liegende Glasübergangstemperatur können unter anderem zu einem Abriß von Bonddrähten und damit zu einem Funktionsausfall des Bauelements führen.

Aus diesem Grund haben sich Epoxidharze als geeignet erwiesen, welche in Verbindung mit einem anorganischen Füllstoff die obengenannten Anforderungen erfüllen. Kommerziell erhältliche Tropfenabdeckmassen sind zum Beispiel gefüllte Zweikomponentenepoxidharze. Ein großer Nachteil derartiger Harze ist die Notwendigkeit, Harz und Härterkomponente vor der Anwendung zu mischen, da bereits vorgemischte Harze nur eine begrenzte Zeit verarbeitungsfähig sind, weil der auch bei Normaltemperatur fortschreitende Härtungsprozeß die Viskosität der Masse ansteigen läßt. Das Mischungsproblem wird durch vorgemischte und im gefrorenen Zustand gehandelte sogenannte "frozen products" vom Anwender zum Hersteller verlagert, doch weisen die vor der Anwendung wieder aufzutauenden Reaktionsharze weitere Nachteile auf. Die begrenzte Zeitdauer, innerhalb der eine Verarbeitung der Harze nur möglich ist, erlaubt nur kurze Standzeiten der Applikationsvorrichtungen. In ebensolchen kurzen Intervallen ist eine gründliche Reinigung sämtlicher mit dem Harz in Kontakt gekommener Teile von reaktiven Harzresten erforderlich, um die Funktionsfähigkeit zu erhalten. Dadurch wird ein kontinuierlicher Produktionsprozeß erschwert, und somit werden technische und wirtschaftliche Nachteile erzeugt.

Aufgabe der vorliegenden Erfindung ist es daher, eine Tropfenabdeckmasse anzugeben, welche die geforderten und oben angegebenen chemisch/physikalischen Eigenschaften aufweist, dabei aber gleichzeitig die angeführten Nachteile der bekannten Tropfenabdeckmassen vermeidet.

Diese Aufgabe wird erfindungsgemäß durch eine Tropfenabdeckmasse gelöst, die die Merkmale des Patentanspruchs 1 aufweist. Weitere Ausgestaltungen der Erfindung sind den Unteransprüchen zu entnehmen.

Die erfindungsgemäße Tropfenabdeckmasse beruht auf einem kationisch härtbaren Epoxidharz, wobei der Härtungsprozeß mit Hilfe eines Photoinitiators durch UV-Licht initiiert wird. Es handelt sich somit um eine im Dunkeln beliebig lange lagerfähige Mischung, die eine einfache und problemlose Handhabung erlaubt. Zur Härtung von Tropfenabdeckungen aus dieser Masse ist kein Temperaturschritt nötig. Wird der Härtungsprozeß durch UV-Licht initiiert, läuft er selbstständig bis zur vollständigen Durchhärtung, also zur Abreaktion aller reaktiven Gruppen weiter. Die Gefahr des Verfließens eines solchen Tropfens, welche bei bekannten Zweikomponentenharzen besteht, wird durch die Erfindung umgangen. Mit den erfindungsgemäßen Massen ist es daher möglich, Tropfen von genau definierter Geometrie, bzw. von vorgegebener Höhe und Fläche zu erzeugen, da diese beim Härten erhalten bleiben und der Tropfen nicht verläuft. Dies ist nämlich als weiterer Nachteil der thermisch härtenden Systeme zu nennen: Die Tropfen neigen zum Verlaufen, wenn sie zu rasch auf eine Temperatur gebracht werden, die eine Härtung in vertretbaren Zeiten erlaubt.

Weiterhin wird durch die erfindungsgemäße dichte Packung des Füllstoffs in der Harzmatrix ein hoher Volumenfüllgrad und ein niedriger Ausdehnungskoeffizient der Tropfenabdeckmasse erzielt. Im Temperaturbereich von Raumtemperatur bis 90°C werden mit den Tropfenabdeckmassen Ausdehnungskoeffizienten von 20 ppm/K und kleiner erreicht. Bei hoher Glasübergangstemperatur von größer als 140°C bleibt ein niedriger Ausdehnungskoeffizient über den gesamten Einsatztemperaturbereich erhalten und die Tropfenabdeckmassen weisen die für Epoxidharze bekannten guten Eigenschaften wie Chemikalienresistenz, hohe mechanische Festigkeit und hohe erzielbare Reinheit auf. Letztere ist insbesonders hinsichtlich des dadurch niedrig gehaltenen Gehalts an den korrosionsunterstützenden bzw. korrosionsauslösenden Alkali-und Chloridionen von großer Bedeutung.

Ein geeigneter Füllstoff für die erfindungsgemäßen Epoxidharzmassen muß einige Voraussetzungen erfüllen. Zunächst muß er, wie bereits erwähnt, mit dem kationischen Härtungsprozeß kompatibel sein. Genauer gesagt darf er keine Wechselwirkungen mit den beim Härtungsprozeß ablaufenden chemischen Reaktionen aufzeigen. Daher scheiden stark basisch reagierende Füllstoffe aus. Weiterhin soll er für das zur Härtung verwendete UV-Licht durchlässig sein, um bei der Bestrahlung eine ausreichende Menge an Photoinitiator auch in größerer Schichtdicke zu zersetzen bzw. anzuregen. Selbstverstständlich sollten diese Füllstoffe auch sonst keine störenden Verunreinigungen besitzen und eine niedrige Alphastrahlen-Emission aufweisen. Für die Festigkeit des Harz/Füllstoffverbundes und die Reproduzierbarkeit der Eigenschaften ist außerdem ein Füllstoff notwendig, bei dem eine definierte Oberfläche und Korngrößenverteilung der Partikel verfügbar bzw. einstellbar ist. Besonders geeignet für die erfindungsgemäßen Tropfenabdeckmassen sind daher Aluminiumoxid, Aluminiumhydroxid, Kalziumcarbonat, Magnesiumoxid, Quarz, Quarzgut und Glas. Eine gezielte Auswahl des Füllstoffes kann bei Bedarf weitere vorteilhafte Eigenschaften erbringen. So wird zum Beispiel mit Aluminiumhydroxid eine schwer brennbare Tropfenabdeckmasse erzeugt. Mit Aluminiumoxid läßt sich eine große Wärmeleitfähigkeit erzielen. Quarz zeigt einen niedrigen Ausdehnungskoeffizienten und läßt sich in hoher Reinheit darstellen. Aus Glas können am leichtesten Füllstoffpartikel beliebiger Form hergestellt werden. Möglich sind zum Beispiel Flakes, Plättchen, kugelförmige Teilchen, kurze Fasern oder auch Hohlkugeln. Quarzgut zeichnet sich durch einen niedrigen thermischen Ausdehnungskoeffizienten von < 1 ppm/K aus. Besonders vorteilhaft wird daher Quarzgutmehl, sogenanntes "fused silica" als Füllstoff verwendet.

Eine besonders dichte Packung wird zum Beispiel erzielt, wenn Korngrößenverteilungen im folgend angegebenen Bereich verwendet werden:
a) 55 bis 95 Gewichtsprozent Partikel von 1 bis 150 µm Durchmesser,
b) 1 bis 35 Gewichtsprozent Partikel von 1 bis 25 µm und
c) 0,5 bis 20 Gewichtsprozent Partikel kleiner 5 µm.

Neben der geeigneten Korngrößenverteilung ist für einen optimalen, also hohen Volumenfüllgrad der Tropfenabdeckmassen die Beschaffenheit der Füllstoffpartikeloberflächen wichtig. Zur besseren Einbettung der Partikel in die Harzmatrix ist es von Vorteil, wenn die Oberflächen der Füllstoffpartikel chemisch behandelt sind. Zur Behandlung wird dazu ein Agens gewählt, mit dessen Hilfe an die Partikeloberflächen organische Reste mit reaktiven Gruppen angebunden werden, die zur Reaktion mit dem Epoxidharz geeignet sind. Beim Härtunsprozeß reagieren diese Gruppen mit dem Harz und sorgen für eine chemische Einbindung der Füllstoffpartikel in die Matrix. Als reaktive Gruppen geeignet sind daher alle Gruppen, die mit Epoxiden reagieren, aber keine Störung des kationischen Härtungsprozesses verursachen. Eine solche Oberflächenbehandlung kann auch die Viskosität der Tropfenabdeckmassen herabsetzen, indem die Gleitfähigkeit der Füllstoffpartikel verbessert wird. Kleinere Füllstoffpartikel können nun besser in Hohlräume zwischen größeren Partikeln eindringen und das dort vorhandene Harz verdrängen und gewissermaßen freisetzen, wodurch ein besseres Fließen der gesamten Masse erreicht wird. Die chemische Einbindung der Füllstoffpartikel in die Harzmatrix bewirkt weiterhin eine bessere Übertragung des guten, weil niedrigen thermischen Ausdehnungskoeffizienten des Füllstoffs auf die gesamte Tropfenabdeckmasse.

Die Auswahl der möglichen Füllstoffe ist jedoch nicht auf anorganische Materialien beschränkt. Ähnlich vorteilhafte Wirkungen können mit der Verwendung von sogenannten Hochleistungskunststoffen erreicht werden. Als bekannte Beispiele aus dieser Gruppe seien Polyethersulfon (PES), Polyphenylensulfid (PPS), Polyetheretherketon (PEEK), Siliconharze und flüssigkristalline Polymere (LCP) genannt. Diese können, gegebenenfalls oberflächenbehandelt, als Pulver, Fasern usw. eingesetzt werden. Selbstverständlich sind auch Mischungen verschiedener anorganischer aber auch anorganischer und organischer Füllstoffe möglich. Als Füllstoffe sind Kunststoffe mit ausreichend ge-ringem thermischen Ausdehnungskoeffizienten geeignet.

Die Auswahl der für die Erfindung einsetzbaren Epoxidharze ist ebenfalls kaum beschränkt. Grundsätzliche Voraussetzungen sind eine kationisch initiierte Härtbarkeit mit ausreichend hoher Härtungsgeschwindigkeit, hohe Glasübergangstemperatur von mehr als 140°C, niedriger Gehalt an Ionen, insbesondere an Alkali- und Chloridionen und außerdem eine hohe mechanische Festigkeit. Grundsätzlich sind dazu fast alle handelsüblichen Harze und deren Abmischungen geeignet. Solche können zum Beispiel aus oligomeren oder polymeren Epoxidharzen vom Glycidylethertyp ausgewählt sein. Als Basis für die Glycidylether können dienen: Bisphenole, zum Beispiel Bisphenol-A; Di- oder Polyhydroxyaromaten, zum Beispiel Resorzin; Polyarylalkyle mit phenolischen OH-Gruppen; Novolake; Polyalkylenglykole oder auch Mehrfachalkohole, zum Beispiel Glycerin oder Pentaerythritol. Weiterhin geeignet sind Epoxyurethanharze; Verbindungen von Glycidylether-Estertyp, zum Beispiel para-Hydroxybenzoesäure-Glycidyletherester; reine Glycidylester von Mehrfachcarbonsäuren mit aliphatischem oder aromatischem Kern, zum Beispiel Hexahydrophthalsäure oder Phthalsäure; lineare aliphatische Epoxidharze, zum Beispiel epoxidiertes Polybutadien, epoxidiertes Sojabohnenöl oder auch cycloaliphatische Epoxidharze. Letztere zeichnen sich durch hohe Reaktivität aus. Ein bekanntes Beispiel ist 3,4-Epoxycyclohexylmethyl-3,4-Epoxycyclohexancarboxylat.

Vorteilhafterweise werden für die erfindungsgemäßen Tropfenabdeckmassen Mischungen aus mehreren dieser Harze eingesetzt. Dadurch können die gewünschten chemisch physikalischen und thermomechanischen Eigenschaften besser eingestellt werden. Zum Beispiel zeigt eine reine Glycidylverbindung oft eine zu geringe Polymerisationsgeschwindigkeit, während zum Beispiel reine cycloaliphatische Epoxidharze meist ungenügende mechanische Eigenschaften besitzen. Geeignete Epoxidharzmischungen bestehen zum Beispiel aus einem Grundpolymer, etwa einem Novolakepoxidharz, einer flexibilisierenden Komponente, zum Beispiel einem epoxidierten Polybutadien, und gegebenenfalls weiteren, niedermolekularen mehrfunktionellen Epoxidverbindungen mit bevorzugt niederer Viskosität. Weniger geeignet sind zum Beispiel viele niedermolekulare Monoepoxide.

Als weitere Komponenten können in der Epoxidharzmischung polymere oder oligomere Verbindungen enthalten sein, die keine Epoxidgruppen aufweisen, wohl aber solche, die mit Epoxidgruppen reagieren können. Als Beispiel sei hier nur ein Copolymer aus Butadien und Acrylnitril genannt, welches endständig mit Carboxyl- oder bevorzugt mit Hydroxylgruppen funktionalisiert ist. Als weitere Komponenten, die mit Epoxidharz copolymerisierbar sind, sind Mehrfach- oder Polyalkohole bzw. deren Vinylether zu nennen. Beispielhaft seien hierzu die Divinylether von Butandiol, Triethylen-glykol oder 1,4-Cyclohexan-Dimethanol aufgezählt. Auch elastifizierende Komponenten können enthalten sein, wobei deren Anteil auf das gewünschte Eigenschaftsprofil abgestimmt ist.

Als letzter Hauptbestandteil ist in der Tropfenabdeckmasse ein Photoinitiatorsystem enthalten. Dieses erfährt bei Bestrahlung mit sichtbarem bzw. UV-Licht eine elektronische Anregung, das heißt, eine Verbindung wird in einen energetisch höher liegenden Zustand versetzt, in dessen Folge eine chemische Veränderung des Photoinitiatorsystems eintritt. Entscheidend für den katalytisch initiierten Polymerisations-prozeß der Epoxide ist, daß dabei ein Säure freigesetzt oder aktiviert wird. Dies kann ein Proton bzw. eine protonierte Spezies oder auch eine Lewis Säure sein, beispielsweise ein Metallion, in dessen Koordinationssphäre schließlich die Polymerisationsreaktion stattfindet. Ist dieser Vorgang einmal ausgelöst, kann er auch im Dunkeln weiterlaufen.

Geeignete Photoinitiatoren sind aus den verschiedensten chemischen Verbindungsklassen bekannt. Eine Gruppe geeigneter Verbindungen stellen zum Beispiel die Salze von stabilen organischen Kationen, insbesonders mit Schwefel oder Jod als Zentralatom dar. Als besonders vorteilhaft haben sich aromatische Oniumsalze erwiesen, zum Beispiel das von der Union Carbide Company angebotene Diphenyl-4-Thiophenoxy-Phenylsulfonium-Hexafluoroantimonat oder -Hexafluorophosphat oder auch das von der Degussa vertriebene Bis-4-(diphenylsulfonio)Phenylsulfid-Bishexafluorophosphat oder -Bishexafluoroantimonat. Ein eine Lewis-Säure enthaltender Photoinitiator kann als Pi-Donor-Übergangsmetallkomplex realisiert werden, beispielsweise das Pi-Cyclopentadienyl-Pi-Isopropylbenzol-Eisen (II)-Hexafluorophosphat (erhältlich als Irgacure 261 von Ciba Geigy). Weiterhin sind zu nennen Phenacylsulfoniumsalze, Hydroxylphenylsulfoniumsalze sowie Sulfoxoniumsalze. Bevorzugte Anionen sind die komplexen Fluoride von Bor, Phosphor, Arsen und Antimon und Anionen von Heteropolysäuren. Als Photoinitiator geeignet sind auch vorgeschlagene Organosiliziumverbindungen, aus denen bei UV-Bestrahlung ein Silanol freigesetzt wird, welches wiederum bei Gegenwart von Aluminiumalkoholaten die Polymerisation initiiert.

Neben den bereits angeführten und für die Erfindung unerläßlichen Bestandteilen können die Tropfenabdeckmassen weitere für Epoxidharze bekannte Zusätze und Additive enthalten. Mit deren Hilfe werden in bekannter Weise verschiedene zusätzliche Eigenschaften erzielt, die insbesondere das Verfahren zum Aufbringen einer solchen Tropfenabdeckmasse verbessern, die Eigenschaften der fertigen bzw. gehärteten Tropfenabdeckmasse jedoch meist kaum beeinflussen. Im folgenden werden beispielhaft einige Additive und die mit ihnen zu erzielenden Vorteile aufgezählt. Der Zusatz von Farbstoff oder Pigmenten kann zur farblichen Anpassung der Tropfenabdeckmasse an ein Bauelement dienen oder die abgedeckte Schaltung bzw. das abgedeckte Bauelement vor unbefugtem Einblick schützen. Dabei ist auf eine ausreichende Durchlässigkeit für UV-Licht zu achten, um den photoinitiierten Härtungsprozeß nicht zu behindern. Thixotropierungsmittel erleichtern das Aufbringen von dicken Abdeckschichten,wobei die Viskosität einer gescherten Kunststoffmasse niedrig, die Viskosität einer mechanisch nicht belasteten Kunststoffmasse erhöht ist. Damit wird ein Verfließen von aufgebrachten Kunststoff- oder Harzstrukturen verhindert. Mit Verlaufsmitteln kann ein besseres Verlaufen einer aufgebrachten Tropfenabdeckmasse auf einem Substrat erreicht werden. Entgasungshilfsmittel sorgen für ein schnelles Entweichen der beim Aufbringen oder Mischen der Tropfenabdeckmasse unvermeidbar mit eingeschlossenen Gasbläschen, welche andernfalls die Eigenschaften der Tropfenabdeckmassen ungünstig beeinflussen würden. Mit Hilfe von Flammschutzmitteln wird die Entflammbarkeit von thermisch belasteten mit der erfindungsgemäßen Masse abgedeckten Bauelementen oder Schaltungen herabgesetzt. Benetzungsmittel vermindern die Abstoßungskräfte zwischen der Unterlage und der Tropfenabdeckmasse, während Haftvermittler die anziehenden Wechselwirkungen der Tropfenabdeckmasse und dem Substrat verstärken. Die beiden letztgenannten Zusätze können dabei auch auf der abzudeckenden Oberfläche aufgebracht werden.

Wird die Tropfenabdeckmasse für Dick- bzw. Dünnschichtwiderstände enthaltende Hybridschaltungen verwendet, ist es besonders vorteilhaft, wenn ein Absorber für Strahlung im langwelligen sichtbaren Bereich bzw. im nahen IR-Bereich in der Abdeckmasse enthalten ist. Dadurch wird Laserstreulicht absorbiert, welches beim Laserabgleich von Dick- bzw. Dünnschichtwiderständen entsteht und die abgedeckten Bauelemente in ihrer Funktion stören kann.

Im folgenden wird anhand von vier Figuren ein Verfahren zum Aufbringen und Härten der Tropfenabdeckmassen beschrieben und vier Ausführungsbeispiele für die Zusammensetzung der Tropfenabdeckmassen angegeben. Dabei zeigt
- die Figur 1: eine Anordnung im Querschnitt, bei der gerade ein Abdecktropfen auf ein eine Schaltung enthaltende Substrat aufgebracht wird,
- die Figur 2: diese Schaltung nach dem Aufbringen zweier Abdecktropfen,
- die Figur 3: einen Ausschnitt aus der Tropfenabdeckmasse und
- die Figur 4: eine Anordnung zum Härten von aufgebrachten Abdecktropfen.

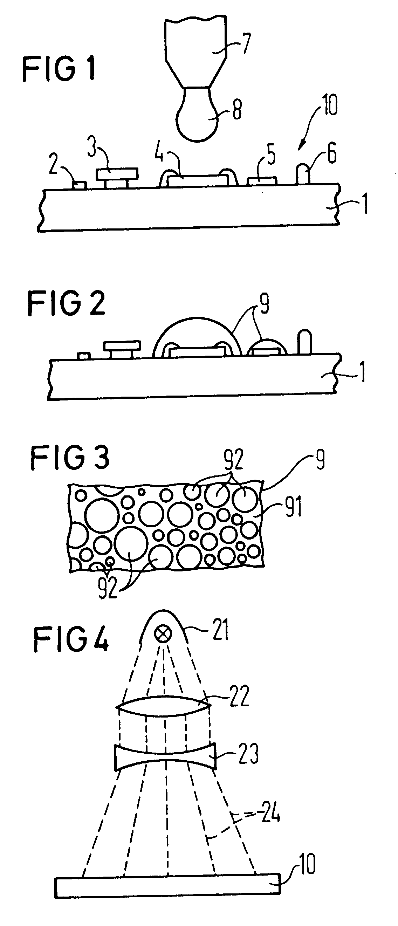

Figur 1: Eine abzudeckende Baugruppe 10 besteht beispielsweise aus einem Substrat 1, welches eine Keramik sein kann. Darauf aufgebrachte elektrische bzw. elektronische Bauteile (2 bis 6) können zum Beispiel IC's, Kondensatoren, Widerstände oder Leiterbahnen sein. Über einen Dispenser 7 wird nun Tropfenabdeckmasse auf die Baugruppe 10 aufgetropft. Der Dispenser ist dabei zum Beispiel als rohrförmige Düse ausgebildet, die das Dosieren einer bestimmten Menge 8 der Tropfenabdeckmasse erlaubt.

Figur 2 zeigt die mit zwei Tropfen 9 der Tropfenabdeckmasse abgedeckten Baugruppe 10. Insbesonders die steilen Flanken der Tropfen 9 zeigen, daß die Abdeckmasse in einer relativ dicken Schicht aufgebracht werden kann, ohne daß die Gefahr des Verfließens besteht. So können die Tropfen 9 gezielt und exakt auf einem gewünschten Bereich der Baugruppe 10 aufgebracht werden. Nicht abzudeckende Bereiche bleiben sowohl vor, als auch nach dem Härten frei, da kein Verfließen erfolgt.

Figur 3 zeigt einen Ausschnitt aus dem Tropfen 9. Gut zu erkennen ist die räumliche dichte Packung der hier kugelförmig dargestellten Füllstoffpartikel 92, die in einer Matrix 91 aus der Epoxidharzmischung eingeschlossen sind. Die Zwischenräume zwischen den größeren Füllstoffpartikeln sind zum größten Teil mit kleineren Füllstoffpartikeln aufgefüllt, womit ein hoher Volumenfüllgrad erreicht werden kann. Dieser hohe Füllgrad ist vor allem für den niedrigen thermischen Ausdehnungskoeffizienten von Bedeutung.

Figur 4 zeigt eine Anordnung zum Härten der Tropfenabdeckmasse. Eine Baugruppe 10, die mit Tropfenabdeckmasse abgedeckte Bereiche aufweist, wird über eine Strahlungsquelle 21 und optional eine zum Beispiel aus Linsen 22 und 23 bestehende Optik bestrahlt. Der Strahlengang ist mit 24 gekennzeichnet. Die Strahlungsquelle 21 ist zum Beispiel eine Quecksilbermitteldruck oder -hochdrucklampe. Doch können auch andere Strahlungsquellen verwendet werden, sofern sie eine ausreichende Lichtintensität erzeugen können. Die Wellenlänge sollte nur so kurzwellig gewählt werden, wie es der Photoinitiator erfordert und kann dementsprechend beliebig mit dem Photoinitiator zusammen variiert werden. Günstig ist ein Photoinitiator, der möglichst langwellig absorbiert und reagiert, weil dadurch eine bessere Tiefenhärtung erzielt wird. Naturgemäß zeigen nämlich die meisten Harze eine erhöhte Absorption im kurzwelligen Bereich, in deren Folge zur vollständigen Härtung der Tropfenabdeckmasse bis in die untersten Schichtbereiche eine höhere Lichtintensität erforderlich ist. Vorteilhaft ist weiterhin eine monochromatische Lichtquelle, sofern sie eine genügende Lichtintensität erzeugen kann. Eine Härtung mit Laser kann technische Vorteile bringen, ist aber kostenaufwendig.

Mit der oben angeführten Quecksilbermitteldrucklampe beträgt die Härtungsdauer bzw. die zur Härtung benötigte Bestrahlungsdauer je nach Zusammensetzung der Abdeckmassen zwischen 10 Sekunden und 10 Minuten, meist jedoch zwischen 1 und 5 Minuten. Neben der Zusammensetzung der Tropfenabdeckmasse ist auch die Höhe der Abdecktropfen für die zur vollständigen Härtung der Abdecktropfen nötige Bestrahlungsdauer maßgeblich, welche bis zu mehreren Millimetern betragen kann.

Im folgenden werden drei Ausführungsbeispiele für vorteilhafte Zusammensetzungen von Tropfenabdeckmassen angegeben und deren wichtigste Eigenschaften in einer Tabelle zusammengestellt. Die angegebenen Bestandteile der drei Ausführungsbeispiele sind in Massenteilen (MT) angegeben und werden in bekannter Weise zusammengemischt. In Klammern ist jeweils die Handelsbezeichnung und der Hersteller angegeben. Das verwendete Quarzgut ist bereits oberflächenbehandelt, was durch die Bezeichnung EST (= Epoxy Silane Treated) ausgedrückt wird.

### 1. Ausführungsbeispiel

- 33,3 MT: cycloaliphatisches Diepoxid (CY 179, Ciba Geigy) 33,3 MT Kresol-Novolak-Epoxidharz (Quatrex 3310, Dow Chemical)
- 33,3 MT: flexibilisierender Reaktivverdünner (UVR 6200, UCC)
- 0,5 MT: Arylsulfoniumhexafluoroantimonat (UVI 6974, UCC)
- 105,1 MT: Quarzgut (FW 61 EST, Quarzwerke Frechen)
- 33,8 MT: Quarzgut (FW 600 EST, Quarzwerke Frechen)
- 3,8 MT: Quarzgut (VP 810-10/1 EST, Quarzwerke Frechen)
- 0,5 MT: Gamma-Glycidoxypropyltrimethoxy-Silan (A 187, UCC)

### 2. Ausführungsbeispiel

Zusammensetzung wie erstes, Ausführungsbeispiel nur andere Mengen der Quarzgutbestandteile.
- 186,7 MT: Quarzgut (FW 61 EST, Quarzwerke Frechen)
- 42,0 MT: Quarzgut (FW 600 EST, Quarzwerke Frechen)
- 4,7 MT: Quarzgut (VP 810-10/1 EST, Quarzwerke Frechen)

### 3. Ausführungsbeispiel

- 25,0 MT: cycloaliphatisches Diepoxid (CY 179, Ciba Geigy)
- 25,0 MT: Kresol-Novolak-Epoxidharz (Quatrex 3310, Dow Chemical)
- 25,0 MT: flexibilisierender Reaktivverdünner (UVR 6200, UCC)
- 25,0 MT: epoxidiertes Sojabohnenöl (Edenol D 82, Henkel)

Übrige Inhaltsstoffe wie Photoinitiator, Füllstoffe und Additive sind in gleichen Massenteilen wie im Ausführungsbeispiel 1 enthalten.

**Tabelle:**

| Eigenschaften der Tropfenabdeckmassen | | | |
|---|---|---|---|
| Ausführungsbeispiel | 1 | 2 | 3 |
| Füllstoffgehalt (nach Gewicht) | 65 % | 70 % | 65 % |
| Füllstoffgehalt (nach Volumen) | 49 % | 55 % | 49 % |
| Viskosität (Pas) | 25 | 63 | 20 |
| Volumenschwund durch Härtung | 2,3 % | 2,0 % | 2,3 % |
| Dichte der gehärteten Massen (g/cm³) | 1,69 | 1,75 | 1,69 |
| Thermischer Ausdehnungskoffizient | | | |
| 25 bis 75°C | 22 | 19 | 25 |
| 175 bis 225°C | 108 | 95 | |
| (ppm/K) | | | |

Den in der Tabelle angeführten Zahlenwerten können die vorteilhaften Eigenschaften der erfindungsgemäßen Tropfenabdeckmassen entnommen werden. Insbesonders die niedrigen Werte für den beim Härtungsprozeß auftretenden Schrumpf und für den thermischen Ausdehnungskoeffizienten machen die angegebenen Massen hervorragend zur Tropfenabdeckung geeignet. Die Gefahr eines Bondabrisses innerhalb einer abgedeckten Schaltung und somit eines Funktionsausfalles ist deutlich verringert. Ebenso ist die Haftung auf dem Substrat verbessert, es kommt zu weniger Ablösungen der Tropfenabdeckmasse.

## Patentansprüche

1. Tropfenabdeckmasse mit niedrigem Ausdehnungskoeffizienten für ungehäuste elektrische und elektronische Bauelemente, enthaltend
a) eine kationisch härtbare Epoxidharzmischung mit einer im gehärteten Zustand bestimmten Glasumwandlungstemperatur größer 140°C,
b) einen mit dem kationischen Härtungsprozeß kompatiblen, für UV-Licht transparenten feinteiligen Füllstoff mit einer maximalen Korngröße von 150 µm und einer Korngrößenverteilung, welche geeignet ist, eine möglichst dichte räumliche Packung zu erzielen,
c) einen Photoinitiator für den kationischen Härtungsprozeß und gegebenenfalls
d) weitere an sich bekannte und für Epoxidharzmassen übliche Zusatzstoffe,
wobei der Füllstoffanteil zwischen 30 und 80 Volumen-Prozent beträgt und die folgende Korngrößenverteilung aufweist:
55 bis 95 Gewichtsprozent Partikel mit einem Durchmesser von 1 bis 150 µm,
1 bis 35 Gewichtsprozent Partikel mit einem Durchmesser zwischen 1 und 25 µm,
1 bis 20 Gewichtsprozent Partikel mit einem Durchmesser kleiner 5 µm.

2. Tropfenabdeckmassen nach Anspruch 1,
**dadurch gekennzeichnet,**
daß der Füllstoff ein anorganischer Füllstoff ist und zumindest eine Komponente enthält, welche ausgewählt ist aus der Gruppe Aluminiumoxid, Aluminiumhydroxid, Kalziumcarbonat, Magnesiumoxid, Quarz, Quarzgut und Glas.

3. Tropfenabdeckmassen nach Anspruch 1,
**dadurch gekennzeichnet,**
daß der Füllstoff organische Polymere enthält, welche ausgewählt sind aus der Gruppe Polyethersulfon, Polyphenylensulfid, Polyetheretherketon, Siliconharze und flüssigkristalline Polymere.

4. Tropfenabdeckmassen nach Anspruch 1,
**dadurch gekennzeichnet,**
daß der Füllstoff ein Kunststoff mit ausreichend geringem thermischen Ausdehnungskoeffizienten ist.

5. Tropfenabdeckmassen nach mindestens einem der Ansprüche 1 bis 4,
**dadurch gekennzeichnet,**
daß die Oberfläche der Füllstoffpartikel mit einem Agens chemisch vorbehandelt ist und infolgedessen organische Reste mit reaktiven Gruppen aufweist, die zur Reaktion mit dem Epoxidharz geeignet sind.

6. Tropfenabdeckmassen nach mindestens einem der Ansprüche 1 bis 5,
**dadurch gekennzeichnet,**
daß die Epoxidharzmischung zusätzlich eine flexibilisierende oder elastifizierende Komponente enthält, deren Anteil auf das gewünschte Eigenschaftsprofil abgestimmt ist.

7. Tropfenabdeckmassen nach mindestens einem der Ansprüche 1 bis 6,
**dadurch gekennzeichnet,**
daß außer Epoxidverbindungen noch Komponenten enthalten sind, die andere, aber mit Epoxiden reagierende funktionelle Gruppen aufweisen.

8. Tropfenabdeckmassen nach mindestens einem der Ansprüche 1 bis 7,
**dadurch gekennzeichnet,**
daß Mehrfachalkohole oder Vinylether von Mehrfachalkoholen enthalten sind.

9. Tropfenabdeckmassen nach mindestens einem der Ansprüche 1 bis 8,
**dadurch gekennzeichnet,**
daß epoxidiertes Sojabohnenöl enthalten ist.

10. Tropfenabdeckmassen nach mindestens einem der Ansprüche 1 bis 9,
**dadurch gekennzeichnet,**
daß eine weitere Komponente enthalten ist, welche Licht des Wellenlängenbereichs absorbiert, welcher die für den Laserabgleich von Dick- bzw. Dünnschichtwiderständen verwendete Strahlung umfaßt.

11. Verwendung der Tropfenabdeckmasse nach einem der Ansprüche 1 bis 10 zur Abdeckung von nicht gehäusten IC's, Hybridschaltungen, Speicherbausteinen oder diskreten Bauelementen.

## Claims

1. Drop coating compound having a low coefficient of expansion for unencapsulated electrical and electronic components, containing
a) a cationically curable epoxy resin mixture having a glass transition temperature determined in the cured state of greater than 140°C,
b) a finely divided filler which is compatible with the cationic curing process and is transparent to UV light and which has a maximum particle size of 150 µm and a particle size distribution suitable for achieving as tight as possible a spatial packing,
c) a photoinitiator for the cationic curing process and, optionally,
d) further additives which are known per se and are standard for epoxy resin compounds,
the filler component being between 30 and 80% by volume and having the following particle size distribution:
55 to 95 per cent by weight of particles having a diameter of 1 to 150 µm,
1 to 35 per cent by weight of particles having a diameter of between 1 and 25 µm,
1 to 20 per cent by weight of particles having a diameter of less than 5 µm.

2. Drop coating compound according to Claim 1, characterized in that the filler is an inorganic filler and contains at least one component selected from the group comprising aluminium oxide, aluminium hydroxide, calcium carbonate, magnesium oxide, quartz, fused silica and glass.

3. Drop coating compound according to Claim 1, characterized in that the filler contains organic polymers selected from the group comprising polyether sulphone, polyphenylene sulphide, polyether ether ketone, silicon resins and liquid-crystalline polymers.

4. Drop coating compound according to Claim 1, characterized in that the filler is a plastic having a sufficiently low coefficient of thermal expansion.

5. Drop coating compound according to at least one of Claims 1 to 4, characterized in that the surface of the filler particles is chemically pretreated with an agent and, as a consequence, has organic residues with reactive groups which are suitable for reaction with the epoxy resin.

6. Drop coating compound according to at least one of Claims 1 to 5, characterized in that the epoxy resin mixture additionally contains a flexibilizing or elasticizing component whose proportion is matched to the desired property profile.

7. Drop coating compound according to at least one of Claims 1 to 6, characterized in that it contains, in addition to epoxy compounds, components having other functional groups, but which react with epoxides.

8. Drop coating compound according to at least one of Claims 1 to 7, characterized in that it contains multiple alcohols or vinyl ethers of multiple alcohols.

9. Drop coating compound according to at least one of Claims 1 to 8, characterized in that it contains epoxidized soya bean oil.

10. Drop coating compound according to at least one of Claims 1 to 9, characterized in that it contains a further component which absorbs light of the wavelength range which covers radiation used for the laser trimming of thick-film and thin-film resistors.

11. Use of the drop coating compound according to one of Claims 1 to 10 for coating unencapsulated ICs, hybrid circuits, memory chips or discrete components.

## Revendications

1. Pâte de recouvrement en goutte avec un faible coefficient de dilatation pour des modules électriques et électroniques non-encapsulés, contenant
a) un mélange de résine époxyde à durcissement cationique avec une température de transition vitreuse supérieure à 140 °C, déterminée à l'état durci,
b) une matière de charge à fines particules, transparente à la lumière UV et compatible avec le processus de durcissement cationique avec une granulométrie maximale de 150 µm et une distribution granulométrique qui est appropriée pour réaliser un tassement volumique le plus dense possible
c) un photoinitiateur pour le processus de durcissement cationique et éventuellement
d) des additifs supplémentaires connus en soi et courants pour les masses de résine époxyde,
où la fraction de matière de charge se situe entre 30 et 80 % volumiques et présente la distribution granulométrique suivante :
55 à 95 % en poids de particules avec un diamètre de 1 à 150 µm,
1 à 35 % en poids de particules avec un diamètre de 1 à 25 µm,
1 à 20 % en poids de particules avec un diamètre inférieur à 5 µm.

2. Pâtes de recouvrement en goutte selon la revendication 1,
caractérisées en ce que,
la matière de charge est une matière de charge inorganique et contient au moins une composante, qui est choisie parmi le groupe de l'oxyde d'aluminium, de l'hydroxyde d'aluminium, du carbonate de calcium, de l'oxyde de magnésium, du quartz, de la silice fondue et du verre.

3. Pâtes de recouvrement en goutte selon la revendication 1,
caractérisées en ce que,
la matière de charge contient des polymères organiques qui sont choisis parmi le groupe des polyéthersulfones, des polyphénylènesulfures, des polyéther-éthercétones, des résines de silicone et des polymères à cristaux liquides.

4. Pâtes de recouvrement en goutte selon la revendication 1,
caractérisées en ce que,
la matière de charge est une matière synthétique avec un coefficient de dilatation thermique suffisamment faible.

5. Pâtes de recouvrement en goutte selon au moins une des revendications 1 à 4,
caractérisées en ce que,
la surface des particules de matière de charge est prétraitée chimiquement avec un agent chimique et qu'elle présente par conséquent des résidus organiques avec des groupes réactionnels, qui sont appropriés pour la réaction avec la résine époxyde.

6. Pâtes de recouvrement en goutte selon au moins une des revendications 1 à 5,
caractérisées en ce que,
la composition de résine époxyde contient en outre une composante de flexibilisation ou d'élastification, dont la fraction est réglée en fonction du profil de caractéristiques souhaitées.

7. Pâtes de recouvrement en goutte selon au moins une des revendications 1 à 6,
caractérisées en ce que,
outre les composés époxydes y sont encore contenues des composantes qui présentent d'autres groupes fonctionnels, mais qui réagissent avec les époxydes.

8. Pâtes de recouvrement en goutte selon au moins une des revendications 1 à 7,
caractérisées en ce que,
des alcools polyvalents ou de l'éther vinylique d'alcools polyvalents y sont contenus.

9. Pâtes de recouvrement en goutte selon au moins une des revendications 1 à 8,
caractérisées en ce que,
de l'huile de soja époxydée y est contenue.

10. Pâtes de recouvrement en goutte selon au moins une des revendications 1 à 9,
caractérisées en ce que,
une composante supplémentaire y est contenue, qui absorbe de la lumière de la région de longueur d'onde qui englobe le rayonnement utilisé pour l'ajustage par laser de résistances à couche épaisse respectivement à couche fine.

11. Utilisation de la pâte de recouvrement en goutte selon une des revendications 1 à 10 pour le recouvrement de circuits intégrés, de circuits hybrides, de modules de mémoire ou de modules discrets, non-encapsulés.
